# EUROPÄISCHE PATENTSCHRIFT

(11) **EP 2 633 097 B1**
(45) Veröffentlichungstag und Bekanntmachung des Hinweises auf die Patenterteilung: **25.04.2018**
(21) Anmeldenummer: 11772901.2
(22) Anmeldetag: 20.10.2011
(51) Int. Cl.: C23C 16/52, C23C 16/54, C23C 14/56, C23C 16/455

(54) **GASSCHLEUSE SOWIE BESCHICHTUNGSVORRICHTUNG MIT EINER GASSCHLEUSE**
GAS LOCK, AND COATING APPARATUS COMPRISING A GAS LOCK
ÉCLUSE À GAZ ET DISPOSITIF DE REVÊTEMENT POURVU D'UNE ÉCLUSE À GAZ

(30) Priorität: 27.10.2010 DE 102010049837
(43) Veröffentlichungstag der Anmeldung: 04.09.2013
(73) Patentinhaber: Fraunhofer-Gesellschaft zur Förderung der angewandten Forschung e.V., 80686 München (DE)
(72) Erfinder: POCZA, David, 79117 Freiburg (DE); REBER, Stefan, 79194 Gundelfingen (DE); ARNOLD, Martin, 79194 Gundelfingen (DE); SCHILLINGER, Norbert, 79241 Ihringen (DE)
(74) Vertreter: Pfenning, Meinig & Partner mbB
(86) Internationale Anmeldenummer: PCT/EP2011/005289
(87) Internationale Veröffentlichungsnummer: WO 2012/055510

(56) Entgegenhaltungen:
- DE-A1- 4 313 284
- DE-C1- 3 050 805
- US-A- 4 285 668
- US-A- 4 438 724
- US-A- 5 443 860
- US-A- 5 919 310

## Beschreibung

Die vorliegende Erfindung betrifft eine Gasschleuse zur Trennung zweier Gasräume, die es ermöglicht, mit minimalem räumlichem Aufwand die Trennung von Gasen ohne Berührung mit dem Produkt/Edukt/Transport-System zu erreichen. Die erfindungsgemäße Gasschleuse zeichnet sich dadurch aus, dass in einem Strömungskanal der Gasschleuse mindestens ein Mittel zur Manipulation der Strömung vorhanden ist. Ebenso betrifft die vorliegende Erfindung eine Beschichtungsvorrichtung, die eine erfindungsgemäße Gasschleuse umfasst. Zudem werden Verwendungsmöglichkeiten der erfindungsgemäßen Gasschleuse angegeben.

Zur Kostenreduzierung werden Beschichtungsanlagen mit dem Bestreben konstruiert, kontinuierliche Edukt- und Produktströme zu erzeugen. Auf zahlreichen Gebieten stellt jedoch die Trennung der Prozessgase in der Anlage und die Trennung der Umgebung von den Prozessgasen ein Problem dar.

Bei kontinuierlichen Anlagen, welche auf herkömmliche Dichtungskonzepte verzichten müssen, treten im Wesentlichen folgende Schwierigkeiten auf:
a) Ein Vermischen der Gase aus verschiedenen Prozessschritten muss ausgeschlossen werden, da dies das Produkt unbrauchbar machen würde (beispielsweise kann der Schichtaufbau signifikant beeinflusst und das Produkt zerstört werden).
b) Die meist toxischen und/oder explosiven Prozessgase müssen zuverlässig von der Umgebung getrennt werden, um Sicherheitsrisiken zu vermeiden (Vergiftungen, Explosionen).
c) Die Trennung der Gase muss detektierbar sein, ohne den Druck in toxischen und/oder explosiven Gasen messen zu müssen. Ein Versagen des Dichtungskonzeptes kann so detektiert werden, bevor sich die Prozessgase vermischen oder aus der Anlage strömen (Prozessabbrüche zerstören das Produkt, Ex-geschützte Geräte stellen einen enormen Kostenfaktor im Anlagenbau dar und werden umgangen).
d) Das Konzept muss räumlich kompakt gehalten werden, um die Anlagen wirtschaftlich zu gestalten.
e) Das Konzept darf keine Abnutzung generieren, um die Up-Time der Anlage so hoch wie möglich zu halten und die Produkte nicht zu beschädigen (kein mechanischer Kontakt zum Transportsystem oder dem Produkt).

Bisher wurden die oben genannten Problematiken durch konventionelles Abdichten der Gasräume durch gasdichte Kammern (mittels mechanischen Dichtungen) gelöst. Dies führt jedoch dazu, dass das Transportsystem nicht kontinuierlich funktionieren kann und die Gefahr der Abnutzung oder Beschädigung (siehe Punkt e)) besteht.
Eine weitere Möglichkeit ist das Verwenden von Gasduschen. Hier besteht jedoch das Problem, dass diese in den derzeit üblichen Formen zu ungerichtet sind und keine, für hochreine Prozesse ausreichend tolerante und wirtschaftliche Gastrennung erzeugen. Dies führt zu den oben genannten Problemen a), b) und c) und zu niedriger Up-Time der Anlage.

Die US5919310 beschreibt eine Gasschleuse zur Trennung zweier Gasräume in einer CVD-Beschichtungsvorrichtung, die einen Einströmkörper mit zwei gegenseitigen Einlasskanälen für ein Gas aufweist und eine Wandung, die so angeordnet ist, dass zwischen dem Einströmkörper und der Wandung ein Spalt ausgebildet ist, der in fluidischer Verbindung mit den Einlasskanälen steht. Weiterhin weist die Gasschleuse zwei Ausströmöffnun-gen für das Gas auf, die in fluidischer Verbindung mit dem Spalt stehen. Die Gasschleuse weist weiterhin Pumpen zur Evakuierung der Gasräume auf.
Ausgehend hiervon ist es daher Aufgabe der vorliegenden Erfindung, eine Gasschleuse mit minimalem räumlichem Aufwand zu schaffen, mit der die Trennung von Gasen ohne Berührung mit dem Produkt/Edukt/TransportSystem ermöglicht werden kann.
Diese Aufgabe wird bezüglich der Gasschleuse mit den Merkmalen des Patentanspruchs 1 gelöst. Mit Patentanspruch 9 wird eine erfindungsgemäße Beschichtungsvorrichtung bereitgestellt, die eine erfindungsgemäße Gasschleuse umfasst. Mit Patentanspruch 10 werden Verwendungszwecke der erfindungsgemäßen Gasschleuse angegeben. Die abhängigen Patentansprüche stellen dabei vorteilhafte Weiterbildungen dar.
Erfindungsgemäß wird somit eine Gasschleuse zur Trennung zweier Gasräume bereitgestellt, die
a) mindestens einen Einströmkörper, der mindestens einen Einlasskanal für ein Gas aufweist, der in eine erste Seite des Einströmkörpers mündet,
b) eine beabstandet zur ersten Seite des Einströmkörpers angeordnete Wandung, wobei zwischen der Wandung und dem Einströmkörper ein Spalt, der in fluidischer Verbindung mit dem Einlasskanal steht, ausgebildet ist,
c) mindestens zwei Ausströmöffnungen für das Gas, die in fluidischer Verbindung mit dem Spalt stehen,
umfasst, wobei in der den Einströmkörper begrenzenden ersten Seite und/oder in der der ersten Seite des Einströmkörpers zugewandten Seite der Wandung mindestens ein Mittel zur Erzeugung einer turbulenten Strömung im Spalt (B) vorhanden ist.
Die erfindungsgemäße Vorrichtung ist dadurch gekennzeichnet, dass der mindestens eine Einströmkörper (K) mindestens zwei Einlasskanäle (H1, H2, ..., Hn) für ein Gas aufweist und der Spalt (B) in fluidischer Verbindung mit den mindestens zwei Einlasskanälen (H1, H2, ..., Hn) steht, wobei mindestens eine Absaugvorrichtung (AS), über die zugeführtes Gas abgesaugt wird, zwischen den Einlasskanälen (H1, H2),..., Hn) angeordnet ist.

Die Wandung kann dabei z.B. als Platte ausgebildet sein. Ebenso ist es möglich, dass die Wandung eine gewisse Krümmung aufweist, beispielsweise die Wandung eines Rohres ist. Der Einströmkörper ist dabei im zuletzt genannten Fall bevorzugt so ausgebildet, dass seine dem Spalt zugewandte Begrenzung ebenso gekrümmt ist, so dass der Spalt an jeder Stelle die gleiche Breite aufweist.

Die Wandung kann dabei ebenso bezüglich des Einströmkörpers beweglich ausgebildet sein, so dass z.B. der zwischen Einströmkörper und Wandung befindliche Spalt in seiner Dimension variiert, z.B. verbreitert oder verschmälert werden kann (vertikale Beweglichkeit). Z.B. kann die Wandung in Form einer Platte beweglich gegenüber dem Einströmkörper ausgebildet sein; für den Fall, dass der Einströmkörper ringförmig um ein Rohr ausgebildet ist, wobei die äußere Rohrbegrenzung mung "unterbinden".
- optional an den jeweiligen Endbereichen der Schleuse weitere Druckmessstellen integriert werden, mit denen der Ausströmdruck aus der Schleuse kontrolliert werden kann,
- optional ist es möglich, die Gasschleuse doppelt oder mehrfach auszulegen und durch eine oder mehrere vorhandene Absaugvorrichtungen die Trennwirkung zu erhöhen.

Erfindungsgemäß ist nunmehr vorgesehen, dass innerhalb des zwischen dem Einströmkörper und der Wandung ausgebildeten Spaltes ein oder mehrere Mittel vorhanden sind, die geeignet sind, die bei Betrieb der Gasschleuse entstehende Strömung des Fluids innerhalb des Spaltes zu manipulieren, z.B. verwirbeln, d.h. geeignet sind, beispielsweise eine turbulente Strömung zu erzeugen. Vorzugsweise sind diese Mittel passiv ausgelegt, d.h. die im Spalt entstehende Strömung wird vorzugsweise nicht durch aktive Agitation des Mittels beeinflusst, sondern dadurch, dass der Querschnitt des Spaltes in Strömungsrichtung des Fluids variiert und dadurch lokal unterschiedliche Strömungsgeschwindigkeiten erzeugt werden, die letztendlich zur Verwirbelung des Fluids beitragen. Diese erzeugten Verwirbelungen haben eine Sperrwirkung für der Strömungsrichtung entgegenströmendes Fluid, so dass mit der erfindungsgemäßen Gasschleuse eine effiziente und dauerhafte Trennung zweier Gasräume bei Betrieb aufrechterhalten werden kann. Insbesondere können die Mittel zur Erzeugung der Turbulenzen z.B. als geeignete Einbauten ausgelegt sein, die einen z.B. turbulenten Bereich erzeugen, mit dem gezielt Druckstufen in der Schleuse etabliert werden können.

Das mindestens eine Mittel kann dabei in der ersten Seiet des Einströmkörpers oder dieser Seiet des Einströmkörpers zugewandten Seite der Wandung angeordnet sein. Ebenso ist es möglich, dass Mittel sowohl im Einströmkörper als auch der Wandung angeordnet sind.

Ein Überprüfen der Schleusenfunktion wird möglich, indem überprüft wird, ob der Ausströmdruck des Inertgases oder unkritischen Gases höher ist als der an den Schleusenenden gemessene Druck.

Die erfindungsgemäße Gasschleuse löst bzw. beseitigt alle oben genannten Probleme a) bis e). Sie stellt die Grundlage für Anlagen dar, deren Transportsystem kontinuierlich arbeitet und deren Gasräume voneinander getrennt sind. Die Erfindung ermöglicht eine Minimierung der räumlicher Ausdehnung der Gasschleuse. Dadurch ist eine optimale Prozess- und Sicherheitskontrolle gegeben. Ferner ist es mit der Erfindung möglich, eine Anlage welche kontinuierlich betrieben wird und/oder mit toxischen und/oder explosiven Gasen arbeitet, in einer normalen Arbeitsumgebung zu installieren. Dabei können alle sicherheitsrelevanten Kriterien eingehalten werden und die Anlagenkosten reduziert werden.

Dabei ist es bevorzugt, dass die den Einströmkörper begrenzende erste Seite und/oder die der ersten Seite des Einströmkörpers zugewandte Seite der Wandung als Mittel zur Manipulation der Strömung mindestens eine, bevorzugt eine Mehrzahl von der ersten Seite des Einströmkörpers ausgehende und in diesen hineinragende bzw. von der der ersten Seite des Einströmkörpers zugewandten Seite der Wandung ausgehende und in die Wandung hineinragende Aussparungen aufweist. Die Aussparungen können beispielsweise als Vertiefungen des Einströmkörpers bzw. in der Wandung ausgebildet sein.

Alternativ oder zusätzlich hierzu kann die den Einströmkörper begrenzende erste Seite und/oder die der ersten Seite des Einströmkörpers zugewandte Seite der Wandung als Mittel zur Erzeugung einer turbulenten Strömung mindestens eine, bevorzugt eine Mehrzahl von der ersten Seite des Einströmkörpers ausgehende und in den Spalt hineinragende bzw. von der der ersten Seite des Einströmkörpers zugewandten Seite der Wandung ausgehende und in den Spalt hineinragende Erhebungen aufweisen. Diese Erhebungen können als Gegenstück zu den oben angesprochenen Aussparungen ausgebildet sein.

Optional können somit innerhalb des Spaltes der Schleuse Strömungsfallen (beispielsweise durch Nuten oder Aussparungen) oder Strömungsbrecher (beispielsweise Auswölbungen) geschaffen werden, welche strömungsmechanisch einen Gasrückzug (beispielsweise durch Jet-Effekte) unterbinden und dadurch die erforderliche Schleusenlänge reduzieren können. Diese beiden speziellen Ausgestaltungen ermöglichen es, innerhalb des Spaltes Verwirbelungen beim Durchströmen des Inertgases zu erzeugen, so dass eine Effizienzsteigerung der Sperrwirkung der Gasschleuse und so eine Verkürzung der Baulänge erzielt werden kann.

Insbesondere ist es vorteilhaft, wenn mindestens eine Aussparung und mindestens eine Erhebung in Kombination miteinander vorhanden sind.

Die Gasschleuse kann bezüglich des mindestens einen Einlasskanals spiegelsymmetrisch aufgebaut sein. Eine spiegelsymmetrische Ausbildung der Gasschleuse sieht beispielsweise vor, dass die Ausströmöffnungen so angeordnet sind, dass die Ausströmrichtung der ersten Ausströmöffnung der Ausströmrichtung der zweiten Ausströmöffnung entgegengesetzt ist.
In einer weiter bevorzugten Ausführungsform kann die Gasschleuse rotationssymmetrisch ausgebildet sein. In einer derartigen Ausführungsform ist die Gasschleuse ringförmig um einen zylindrischen Körper angeordnet. Dabei dient die Oberfläche des zylindrischen Körpers als Wandung. Der zylindrische Körper kann dabei beispielsweise ein Rohr sein, das im Inneren hohlförmig ist. Zwischen der Wandung und dem Einströmkörper ist dabei ein ringförmiger Spalt, der um den zylindrischen Körper verläuft, ausgebildet, durch den das Gas strömen kann.
Ebenso ist es möglich, dass die Gasschleuse beide Symmetrieformen aufweist, d.h. sowohl spiegelsymmetrisch, beispielsweise bezüglich der Messkammer, als auch rotationssymmetrisch, d.h. beispielsweise auf einem Rohr, wobei die Rohroberfläche als Wandung dient, ausgebildet ist.
Bevorzugt ist außerdem, dass der Spalt im Wesentlichen lotrecht zum mindestens einen Einlasskanal verläuft. Ebenso sind jedoch gewinkelte Verläufe denkbar.

In der erfindungsgemässen Ausgestaltungsform der Gasschleuse ist vorgesehen, dass mindestens eine Möglichkeit zum Absaugen von Gas vorhanden ist. Diese ist zwischen zwei vorhandenen Einströmkanälen angeordnet. Eine bevorzugte Ausführungsform sieht vor, dass in der den Einströmkörper begrenzenden ersten Seite und/oder in der der ersten Seite des Einströmkörpers zugewandten Seite der Wandung mindestens eine bevorzugt mindestens zwei Messkammern zur Messung mindestens einer physikalischen und/oder chemischen Eigenschaft des Gases (z.B. Druck und/oder Temperatur oder die chemische Zusammensetzung) vorhanden sein können.

Ferner ist bevorzugt, dass auf der dem Einströmkörper abgewandten Seite der Wandung mindestens ein weiterer Einströmkörper angeordnet ist oder eine Mehrzahl von abwechselnd angeordneten Einströmkörpern und Wandungen angeordnet ist. Diese Ausführungsform sieht vor, dass auch in vertikaler Richtung eine Aufteilung der Schleuse in mehrere Teilgasschleusen vorgenommen werden kann.

Erfindungsgemäß wird ebenso eine Beschichtungsvorrichtung oder eine Wärmebehandlungsvorrichtung beansprucht, die mindestens eine zuvor beschriebene Gasschleuse umfasst. Die Beschichtungsvorrichtung umfasst dabei zwei Gasräume, die von der erfindungsgemäßen Gasschleuse getrennt sind, d.h. die Gasschleuse ist zwischen den Gasräumen angeordnet.

Erfindungsgemäß werden ebenso Verwendungszwecke der erfindungsgemäßen Gasschleuse angegeben. Insbesondere eignet sich diese zur Aufrechterhaltung eines bestehenden Konzentrationsgradienten eines und/oder mehrerer Gase und/oder zur Aufrechterhaltung einer Separierung verschiedener Gase zwischen zwei Gasräumen.

Die vorliegende Erfindung wird anhand der nachfolgenden Figuren näher erläutert, ohne die Erfindung auf die dargestellten speziellen Ausgestaltungen zu beschränken.

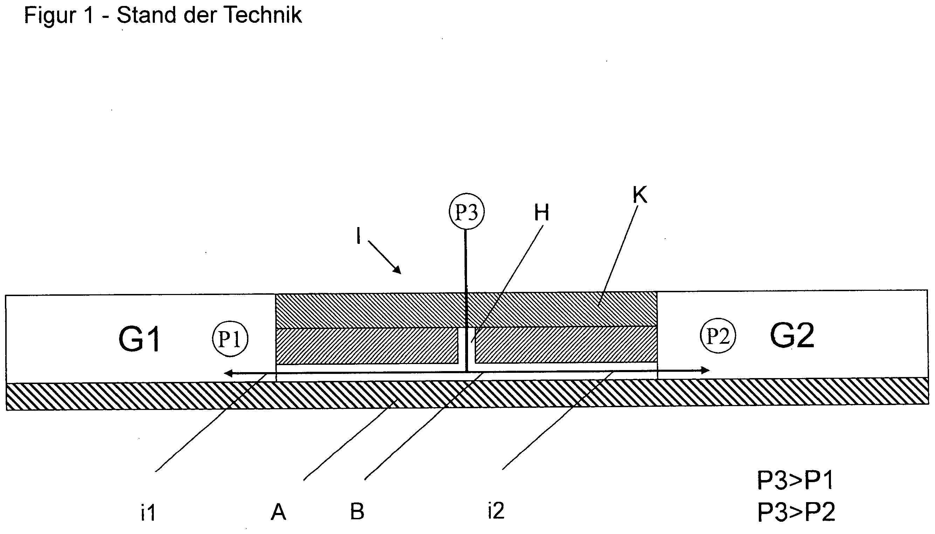

In Figur 1 ist eine aus dem Stand der Technik bekannte Gasschleuse dargestellt. Die Gasschleuse I dient dabei der Trennung zweier Gasräume G1 und G2 und ist insofern zwischen diesen Gasräumen angeordnet. Umfasst ist ein Einströmkörper K, der einen mittig im Einströmkörper K angeordneten Einlasskanal H aufweist. Gegenüber dem Einströmkörper K ist eine als Platte A ausgebildete Wandung angeordnet, so dass zwischen der Platte A und dem Einströmkörper K ein Spalt B ausgebildet wird. Mit i1 und i2 werden die jeweiligen Ausströmöffnungen, die sich an den Ausgängen der Gasschleuse I zu den Gasräumen G1 und G2 befinden, bezeichnet. Das Inertgas/unkritische Gas i1 bzw. i2 strömt den Gasräumen G1 bzw. G2 entgegen. Mit P1 und P2 sind die jeweiligen Gasdrücke in den jeweiligen Gasräumen G1 und G2 bezeichnet. P3 ist der Druck des Inertgases innerhalb der Zuleitungen des Schleusengases. Die Gasschleuse funktioniert umso effektiver, je höher P3 gegenüber P1 bzw. P2 ist. Diese Gasschleuse wird, wie es auch schon in der Figur angedeutet ist, derart betrieben, dass der Druck des einströmenden Gases P3 größer sein muss als die in den jeweiligen Gasräumen G1 und G2 vorherrschenden Drücke P1 und P2. Diese Schleuse lässt sich nur sehr ungenau betreiben, da eine sehr hohe Druckdifferenz zwischen P3 und P1 und/oder P2 benötigt wird, um einen stofflichen Gradienten der Gaszusammensetzung in den Räumen G1 und G2 aufrechtzuerhalten.

Diese grundlegenden, zur Figur 1 gemachten Ausführungen (z.B. die Bezugszeichen) gelten uneingeschränkt auch für die nachfolgend dargestellten erfindungsgemäßen Ausführungsformen.

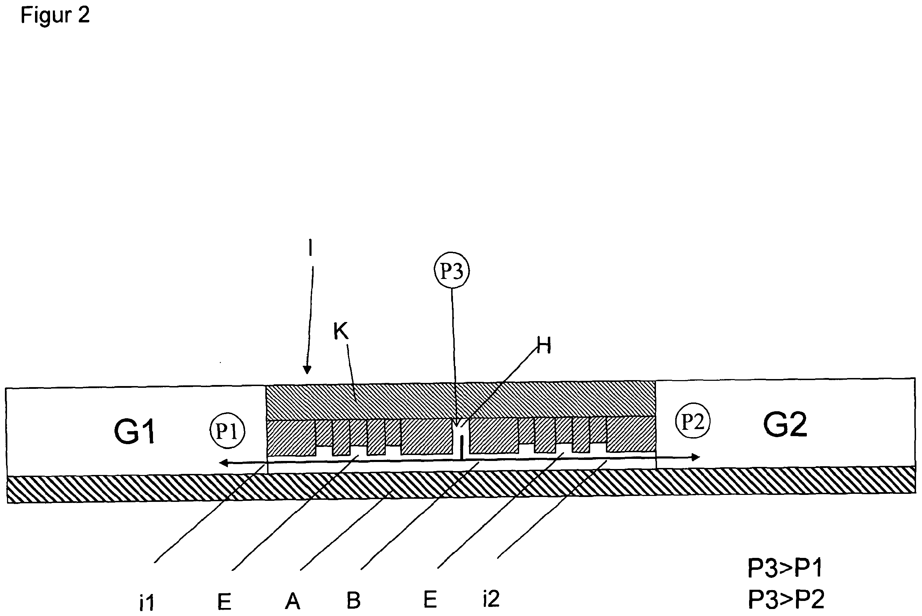

Die Figuren 2 bis 16 stellen allesamt Ausführungsformen einer Gasschleuse dar.

Eine erste Ausführungsform einer Gasschleuse ist in Figur 2 dargestellt. Diese Ausführungsform unterscheidet sich von der in Figur 1 dargestellten Ausführungsform, dass zusätzlich eine oder mehrere (im vorliegenden Fall sechs) Aussparungen E in die Unterseite des Einströmkörpers K eingebracht sind, wobei diese den Einströmkanal H flankieren. Diese Aussparungen E können beispielsweise in Form von Einkerbungen oder Vertiefungen in der Oberfläche des Einströmkörpers K ausgebildet sein. Im Falle einer spiegelsymmetrischen Ausbildung der Gasschleuse sind die Einkerbungen E parallel zueinander verlaufend, beispielsweise in Querrichtung zu den jeweiligen mit den Pfeilen angedeuteten Hauptströmungsrichtungen des
Inertgases ausgebildet. Die Aussparungen E können sowohl vom Einströmkörper K als auch der Platte A (nicht dargestellt) aus erfolgen. Diese fungieren als Strömungsfallen und unterbinden einen Gasrücktransport unter turbulenten oder kritischen Betriebsbedingungen. Zusätzlich kann durch eine solche Konstruktion die Schleusenlänge (Länge des Spaltes B in Richtung der jeweiligen Gasräume G1 und G2) minimiert werden.

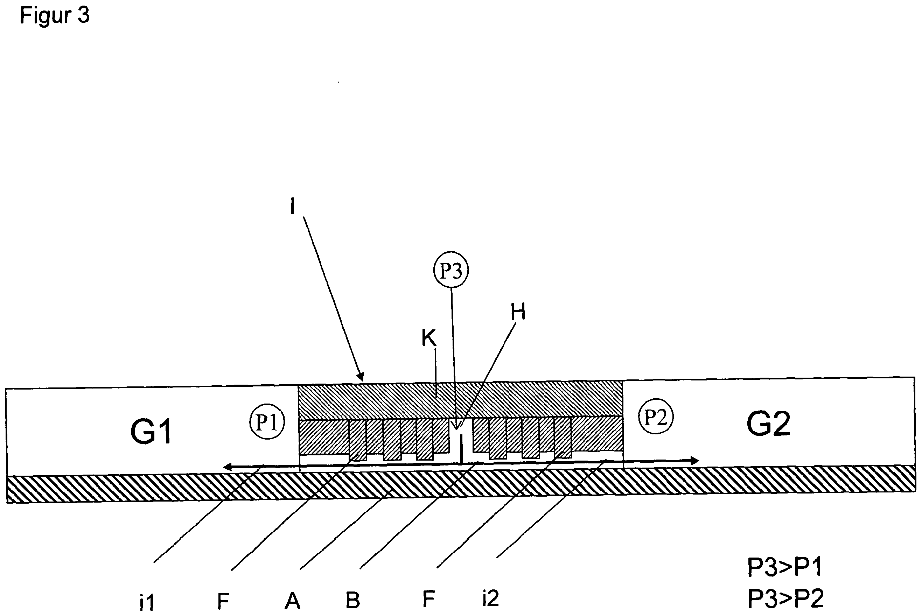

In Figur 3 ist das umgekehrte Konzept zur Ausführung gemäß Figur 2 dargestellt. Anstelle der in Figur 2 dargestellten Aussparungen E weist die Ausführungsform gemäß Figur 3 von der Unterseite des Einströmkörpers K ausgehende und in den Spalt B hinein ragende Erhebungen F auf. Dies kann sowohl vom Einströmkörper K als auch der Platte A aus erfolgen. Diese funktionieren als Strömungsbrecher und verhindern einen Gasrücktransport unter turbulenten oder kritischen Betriebsbedingungen. Zusätzlich kann durch eine solche Konstruktion die Schleusenlänge minimiert werden.

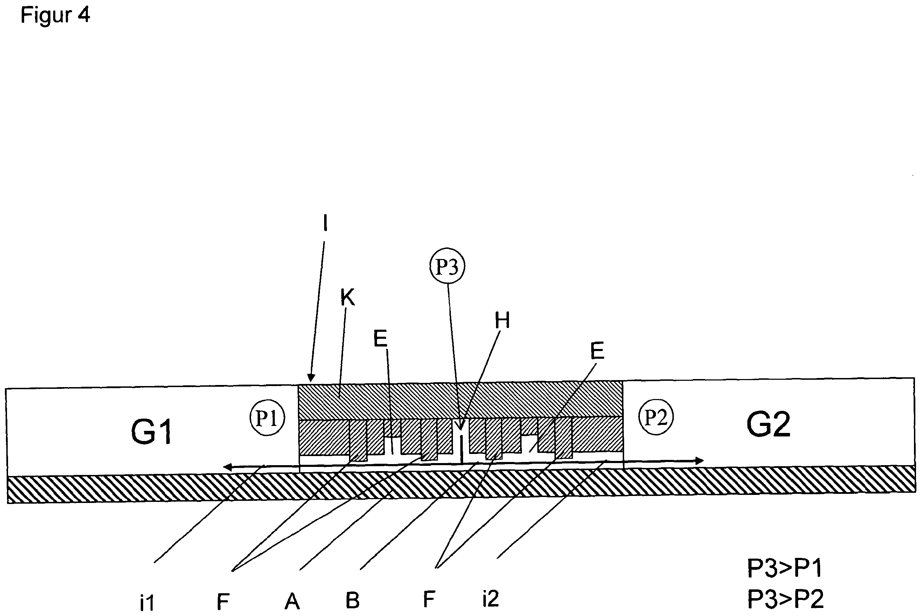

Figur 4 betrifft eine Kombination der in den Figuren 2 und 3 dargestellten Maßnahmen. Die hier dargestellte Gasschleuse I weist einen Einströmkörper K auf, der sowohl Aussparungen E als auch Erhebungen F aufweist. Ebenso ist die Möglichkeit gegeben, dass die Aussparungen E und Erhebungen F in der Platte A ausgebildet sein können (nicht dargestellt).

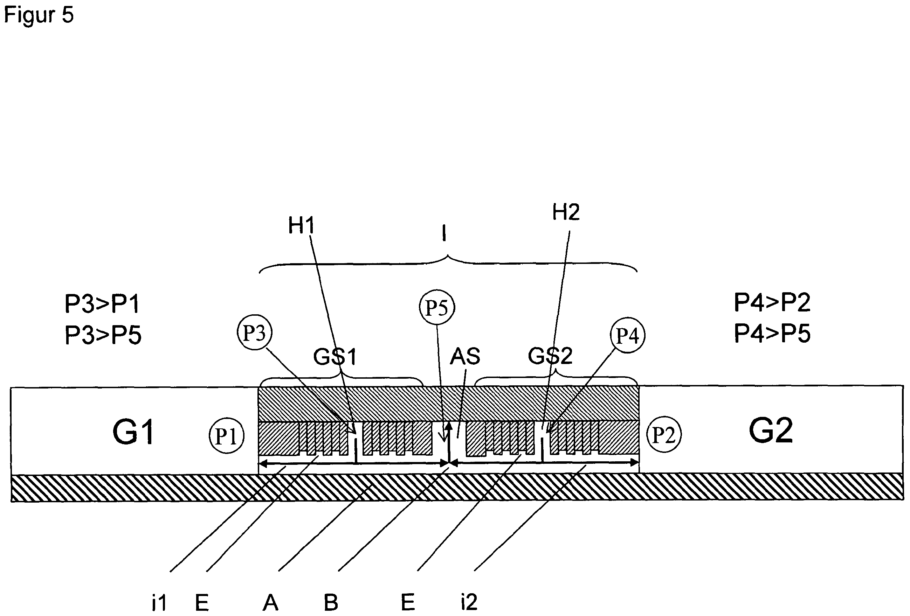

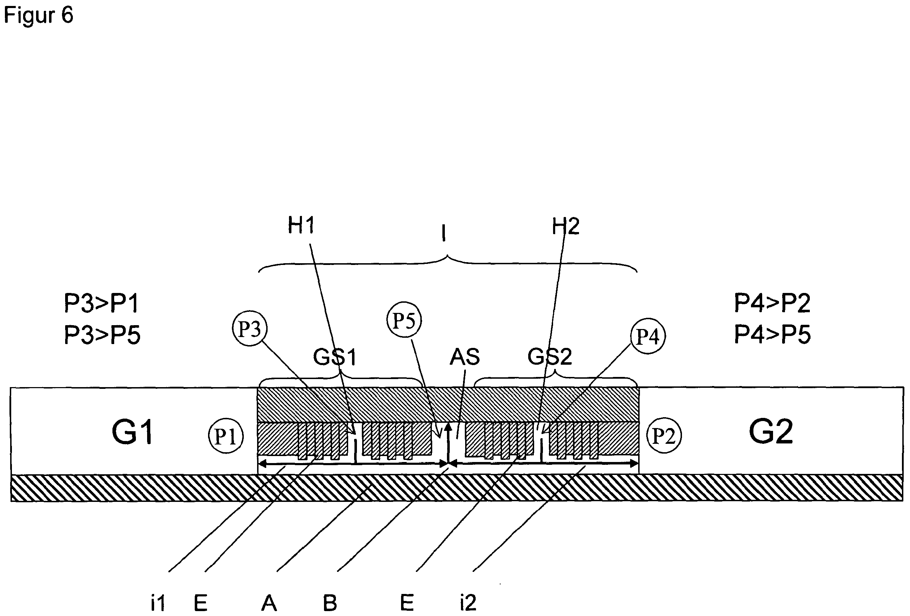

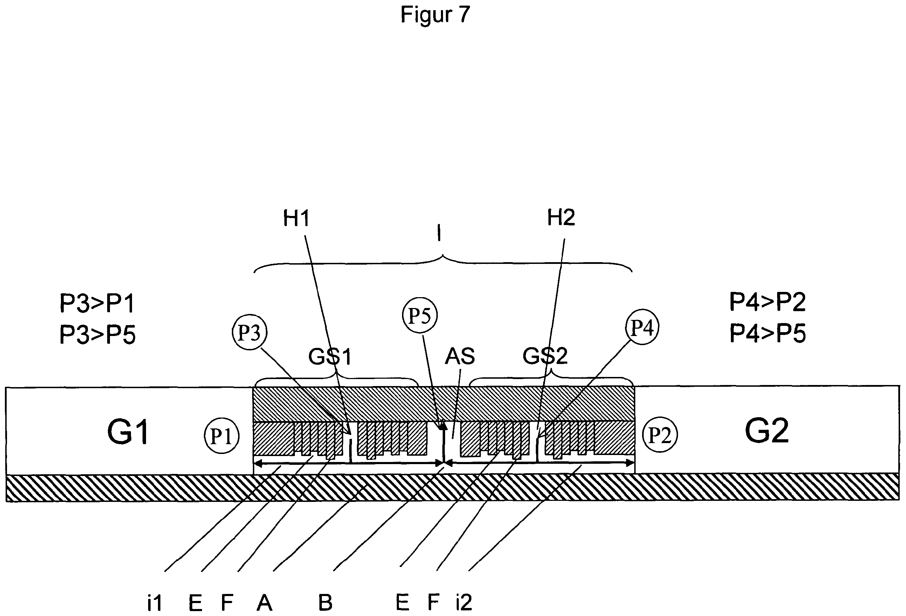

In Figur 5 ist eine erfindungsgemässe Form einer Gasschleuse I ausgeführt, die aus zwei Teilgasschleusen GS1 und GS2 gebildet ist. Diese beiden Teilgasschleusen GS1 und GS2 sind dabei im Wesentlichen analog einer einzelnen Gasschleuse gemäß einer Ausführungsform der Figur 2 ausgebildet und werden aneinander gereiht, um die gesamte Gasschleuse I zu bilden. Diese Ausgestaltung der beiden Teilgasschleusen GS1 und GS2 ist jedoch lediglich beispielhafter Natur, ebenso können diese beiden Teilgasschleusen GS1 und/oder GS2 gemäß einer beliebigen, in den voranstehenden Figuren dargestellten Ausführungsform ausgebildet sein und somit auch die oben angesprochenen Strömungsbrecher, z.B. in Form von Erhebungen oder Aussparungen umfassen. Eine derartige Ausführungsform, die auf das in Fig. 3 vorgestellte Konzept zurückgreift, ist in Fig. 6 dargestellt, während Fig. 7 eine Gasschleuse I zeigt, die aus zwei Teilgasschleusen GS1 und GS2 gebildet ist, wobei innerhalb des Spaltes B sowohl Erhebungen F als auch Vertiefungen E als Mittel zur Erzeugung turbulenter Strömungen vorhanden sind. Zwischen den beiden Teilgasschleusen GS1 und GS2 der Ausführungsformen der Fig. 5 bis 7 ist eine Absaugmöglichkeit AS vorgesehen, über die zugeführtes Gas abgesaugt werden kann. Die beiden Teilgasschleusen GS1 und GS2 verfügen dabei jeweils über separate Gaszuführungen H1 (bei GS1) bzw. H2 (bei GS2). Im Betrieb einer derartigen Gasschleuse I gilt für die Drücke, die in den jeweiligen Regionen der Gasschleuse bzw. den zwei Gasräumen G1 und G2 vorherrschen, P3>P1, P3>P5, P4>P2 und P4>P5, wobei die Messstellen der Drücke in der Gasschleuse I mit den eingekreisten Bezugszeichen versehen sind.

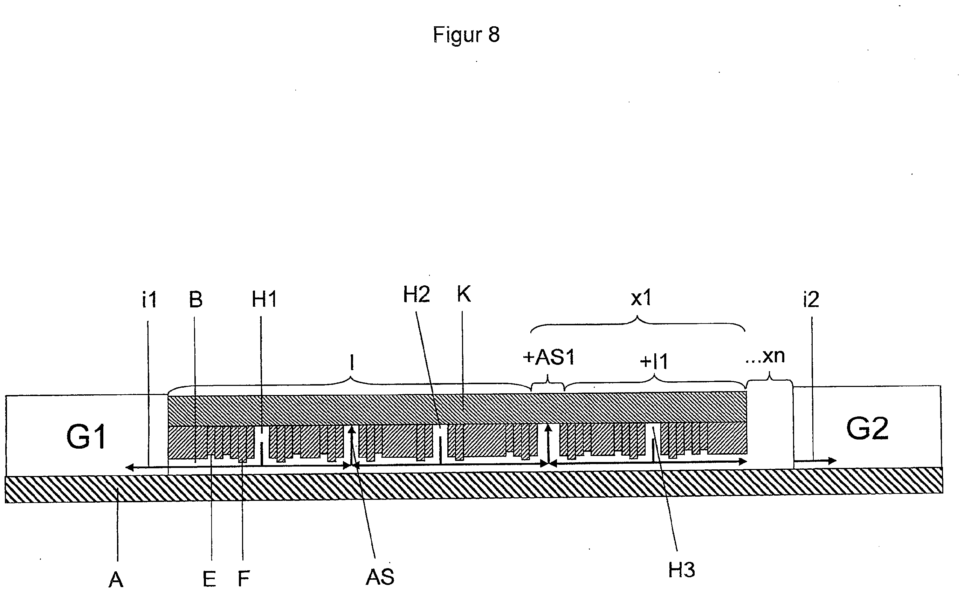

Figur 8 stellt eine weitere Ausführungsform der Erfindung dar, wobei hier eine Gasschleuse I dargestellt ist, die eine n-fache Aneinanderreihung von Teilgasschleusen GS1, GS2, ..., GSn umfasst. Zwischen jedem der vorhandenen Teilgasschleusen ist eine Absaugmöglichkeit AS für Gas vorgesehen. Die hier dargestellte Ausführungsform stellt die logische Erweiterung der in Figur 7 dargestellten Ausführungsformen um n weitere Teilgasschleusen dar.

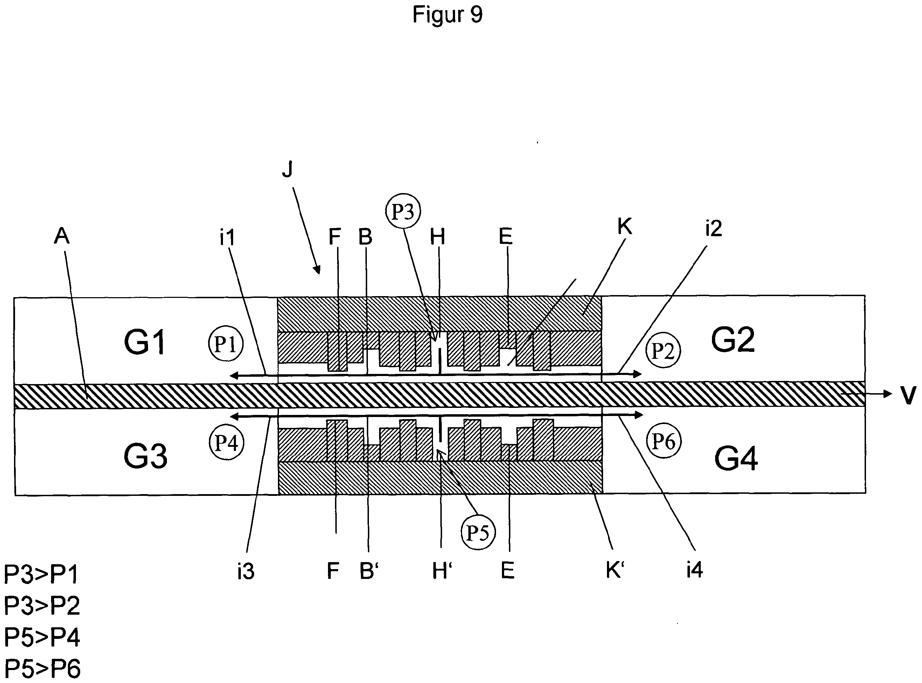

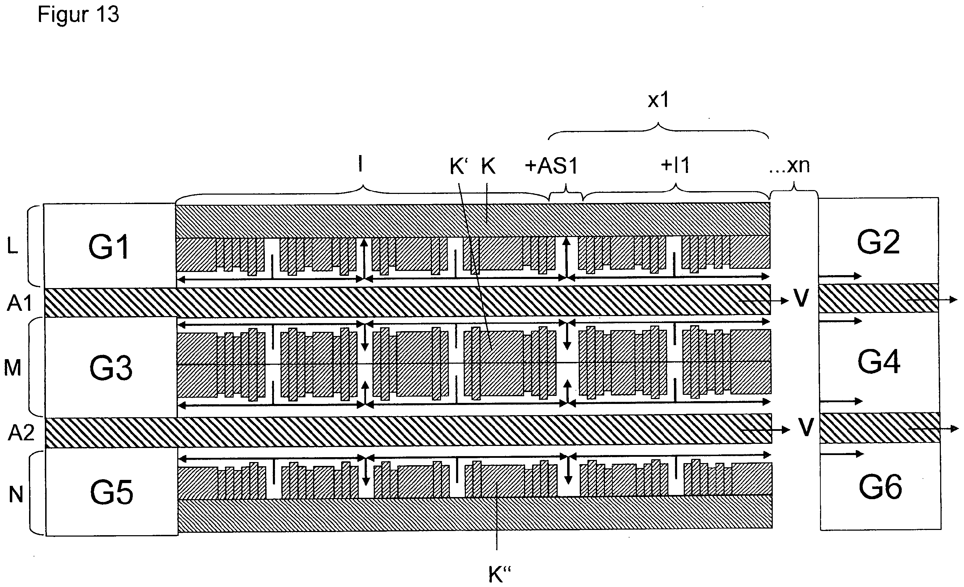

In Figur 9 ist eine weitere Ausführungsform der Gasschleuse dargestellt, die im Gegensatz zu den voranstehenden Ausführungsformen der Gasschleuse anstelle eines einzelnen Einlasskörpers zwei Einlasskörper K und K' aufweist, wobei diese Einlasskörper durch eine Platte A voneinander getrennt sind. Die jeweiligen Einlasskanäle H bzw. H' münden dabei jeweils in Richtung auf die zwischen den beiden Einlasskörpern K und K' liegende Platte A. Insofern betrifft diese Ausführungsform der vorliegenden Erfindung eine um einen weiteren Einlasskörper erweiterte Ausführungsform gemäß Figur 4. Eine entsprechende Erweiterung, wie hier dargestellt, ist jedoch auch mit den in den Figuren 2 und 3 dargestellten Gasschleusen I möglich. Die beiden Einlasskörper K und K' müssen dabei nicht, wie in Figur 13 dargestellt, symmetrisch bezüglich der Platte A beabstandet angeordnet sein, es ist auch eine asymmetrische Beabstandung der beiden Einlasskörper K von der Platte A möglich. Die sonstigen Bezugszeichen sind denen der Figur 4 entlehnt, wobei die in der zusätzlichen Gasschleuse, die durch den Einströmkörper K' und die Platte A gebildet wird, mit einem Strich versehen sind. Dabei kann die zwischen den beiden Einströmkörper K und K' liegende Platte A beweglich ausgebildet sein. Diese kann, wie in der Figur rechts durch v angedeutet, beispielsweise horizontal beweglich führbar sein. Zusätzlich oder alternativ hierzu ist jedoch ebenso eine vertikale Beweglichkeit der Platte A denkbar, so dass beispielsweise die Breite eines der beiden Spalte B oder B' auf 0 reduziert und somit eine Gasschleuse verschlossen werden kann. Durch diese in Figur 9 dargestellte Gasschleuse ist eine Abtrennung von insgesamt vier Gasräumen G1 bis G4 voneinander möglich. Die entsprechenden Druckverhältnisse, die bei Betrieb der Gasschleuse herrschen müssen, sind wie auch schon in den voranstehenden Figuren mit dem jeweiligen Referenzzeichen P1 bis P6 angegeben, wobei die jeweiligen idealen Drücke in der Figur dargestellt sind.

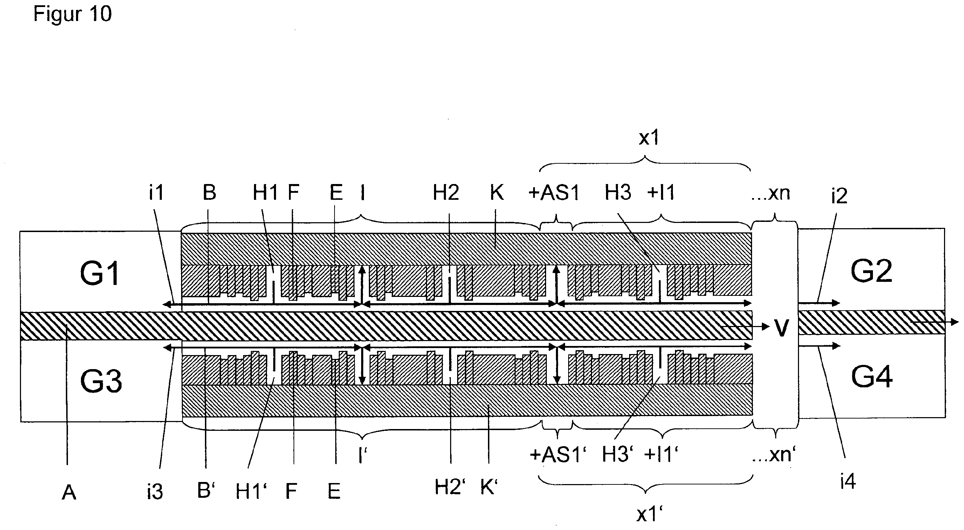

Die Ausführungsform der Gasschleuse, bei der mehrere Einlasskörper K, K', ..., Kn vorhanden sind, kann auf jedes der in Figur 1 bis 8 dargestellten Schleusenprinzipien übertragen werden. Lediglich als Beispiel hierfür zeigt Figur 10 eine weitere Ausgestaltung eine weitere Ausgestaltung einer erfindungsgemäßen Gasschleuse I, die einer Verdoppelung der in Figur 8 dargestellten Gasschleuse entspricht, wobei ein weiterer Einströmkörper K' mit den entsprechenden Ausgestaltungen (d.h. auch hier sind beispielsweise Absaugmöglichkeiten vorhanden etc.), ausgebildet ist. Zu den prinzipiellen abgebildeten Bestandteilen wird auch auf die Ausführungen zur Figur 8 verwiesen. Die zwischen den beiden Einströmkörpern K und K' angeordnete Platte A kann gemäß den Ausführungsformen der Figur 9 ausgebildet sein.

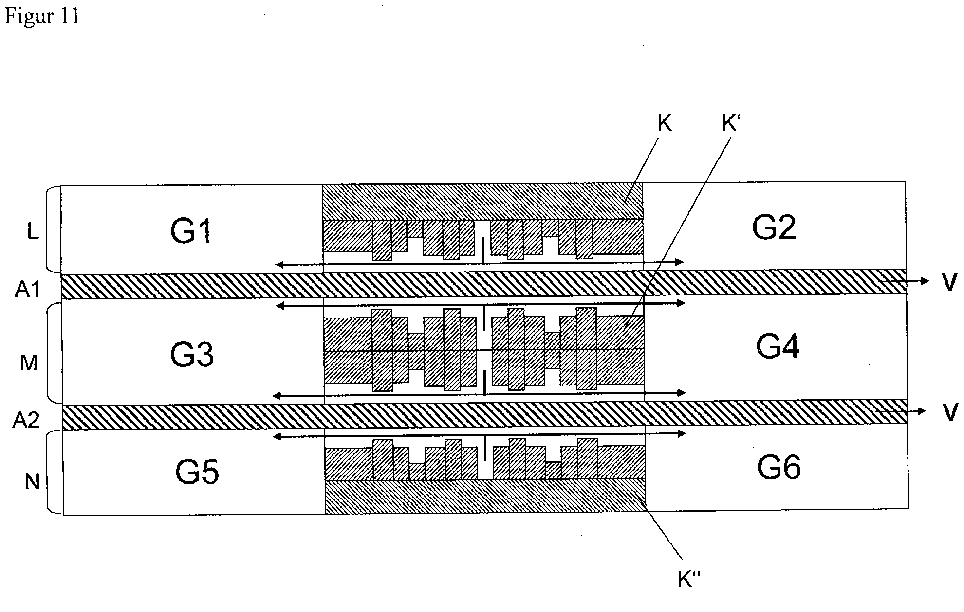

Das in Figur 9 angesprochene Konzept einer Gasschleuse, die mehr als einen Einströmkörper K aufweist, ist ebenso, wie in Figur 11 in einer speziellen Ausgestaltungsform näher erläutert, um eine vertikale Dimension beliebig erweiterbar. Hier ist eine Gasschleuse I dargestellt, die aus drei Teilgasschleusen L, M und N aufgebaut ist. Die Teilgasschleuse L mit einem Einströmkörper K ist dabei der in Figur 4 dargestellten Ausführungsform nachempfunden. Der Übersichtlichkeit halber wird in dieser Figur auf die näheren Bezugszeichen verzichtet; die Gasschleusen sind dabei allesamt wie in Figur 4 dargestellt ausgebildet. Ebenso können bezüglich der Prinzipien der Mittel zur Erzeugung von Turbulenzen auch auf die in den Fig. 2 und 3 dargestellten Prinzipien zurückgegriffen werden. Die Teilgasschleuse L mit dem Einströmkörper K wird durch eine beweglich angeordnete Platte A1 begrenzt. An die Platte A1 schließt sich die zweite Teilgasschleuse M an, die zwischen den Teilgasschleusen L und N gelegen ist. Diese Teilgasschleuse wird auf der einen Seite durch die Platte A1, auf der anderen Seite durch die Platte A2 begrenzt. Auch die Platte A2 ist dabei beweglich ausgebildet, gemäß der Darstellung in der Figur in horizontaler Richtung. Der Einströmkörper K' der Teilgasschleuse M ist dabei so ausgebildet, dass er Auslasskanäle auf beiden Seiten aufweist, d.h. Auslasskanäle in Richtung der Platte A1 und der Platte A2. Die Teilgasschleuse N ist durch einen Einströmkörper K" gebildet, der spiegelsymmetrisch zur ersten Teilgasschleuse L ausgebildet ist.

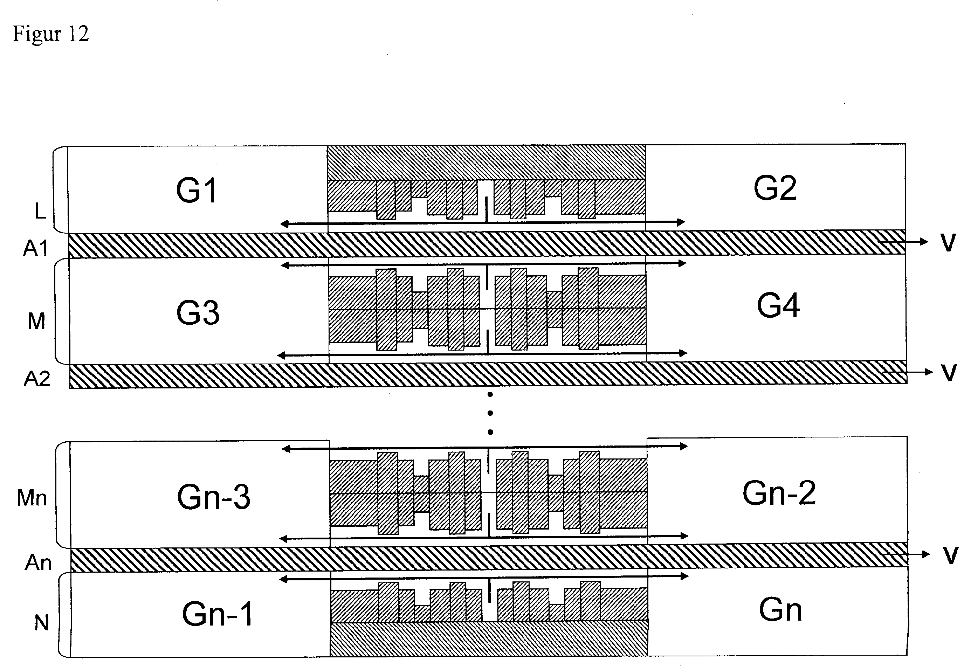

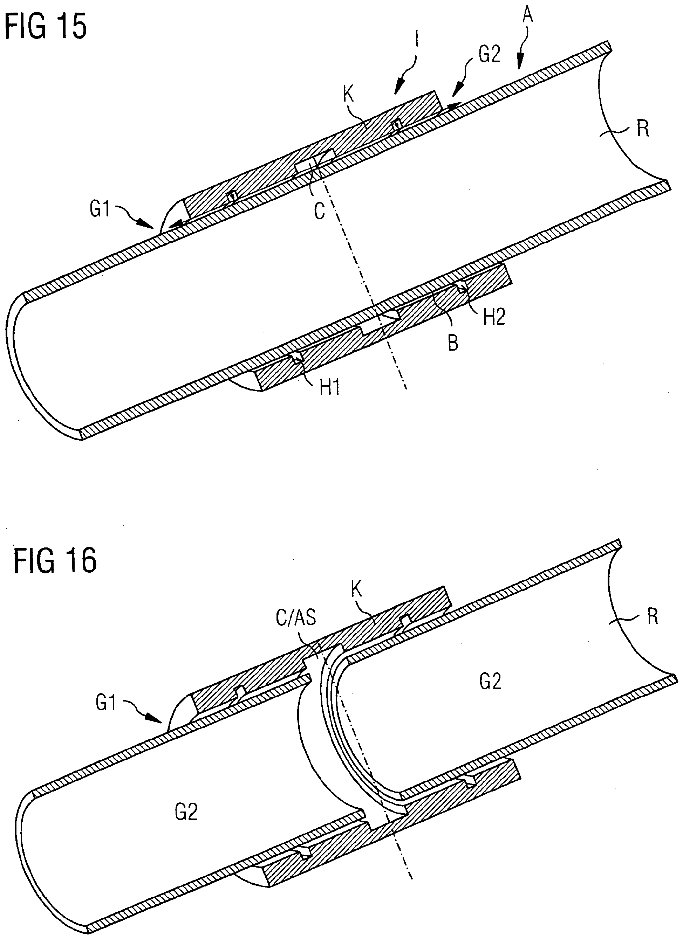

Figur 12 zeigt schließlich die Erweiterung des in Figur 11 vorgestellten Konzepts in Form einer multiparallelen Mehrfachschleuse für n bewegliche Platten A1...An. Anstelle einer einzelnen Teilgasschleuse M, die zwischen zwei terminierenden Teilgasschleusen L und N beinhaltet ist, wie dies in Figur 11 dargestellt ist, weist die Ausführungsform gemäß Figur 16 n verschiedene Teilgasschleusen auf, die jeweils durch eine Platte A voneinander separiert sind. Die die Teilgasschleuse Ml...Mn bildenden Einströmkörper sind dabei dem Einströmkörper K' der Teilgasschleuse gemäß Figur 11 nachempfunden. Diese Ausführungsform ermöglicht die Separierung von insgesamt bis zum G2n verschiedenen Gasräumen. Die weiteren Details einer derartigen multiparallelen Mehrfachschleuse, insbesondere hinsichtlich der Beweglichkeit der Platten A ist bereits in Figur 11 ausführlich beschrieben.

Selbstverständlich ist ebenso die Möglichkeit gegeben, dass die in den Figuren 11 und 12 dargestellten Schleusen gemäß einer der in den Figuren 2 und 3 dargestellten Ausführungsformen gestaltet sind.

In Figur 13 ist eine Übertragung des zuvor in Figur 11 dargestellten Konzeptes auf die Ausführungsform gemäß Fig. 10 dargestellt. Mit anderen Worten wird die in Figur 10 beschriebene Gasschleuse I, die n Absaugmöglichkeiten AS aufweist, in vertikaler Richtung um eine weitere, dritte Teilgasgasschleuse N ergänzt. Bezüglich der weiteren Details sei auf die Ausführungen gemäß Fig. 10 und 11 verwiesen, die auch für Fig. 13 uneingeschränkt gelten.

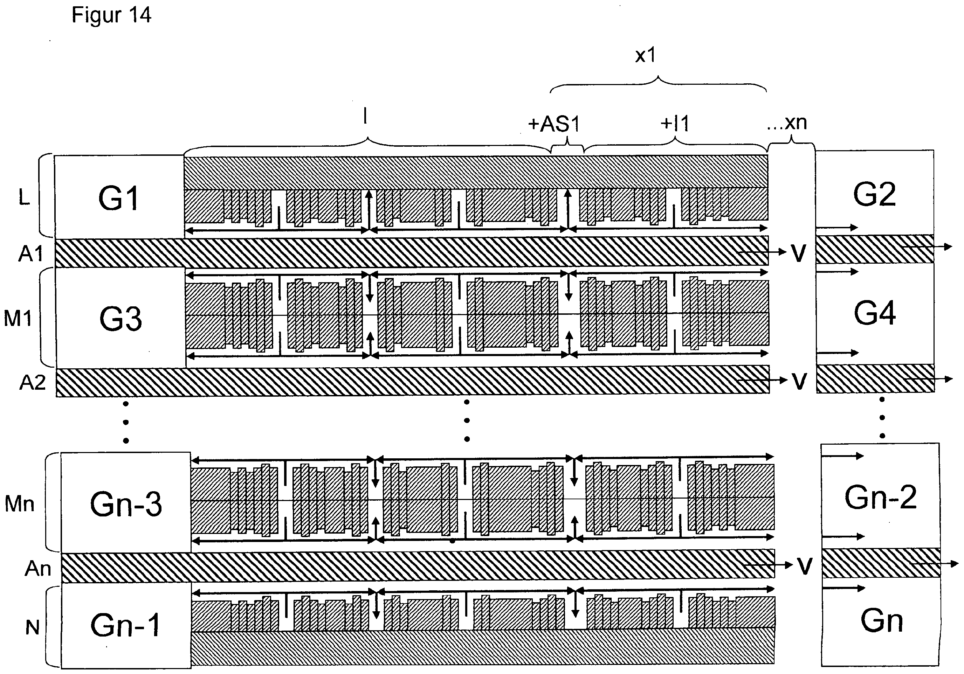

Das in Figur 12 dargestellte Konzept der vertikalen Erweiterung der Gasschleuse lässt sich ebenso mit der in Fig. 10 bzw. 13 vorgestellten Gasschleuse fortsetzen. Die hier in Fig. 14 dargestellte Gasschleuse weist nebeneinander angeordnete horizontale Teilgasschleusen mit jeweils dazwischenliegenden Absaugmöglichkeiten auf sowie n in vertikaler Richtung angeordnete Teilgasschleusen mit jeweils dazwischenliegenden Platten A. Schleusenanzahl n in horizontaler und n in vertikaler Richtung kann dabei gleich oder verschieden sein. Dies hat auch Gültigkeit für die Ausführung gemäß Fig. 11.

Bei allen zuvor gemachten Ausführungen kann die Platte A bezüglich des Einströmkörpers oder der Einströmkörper in fixiertem Abstand angeordnet, aber auch beweglich ausgebildet sein, so dass eine Variation der Spaltbreite und/oder eine Variation der horizontalen Position der Wandung relativ zum Einströmkörper möglich ist.

Figur 15 zeigt eine rotationssymmetrische Ausbildung der Gasschleuse. Hierbei ist die Gasschleuse I durch einen rotationssymmetrisch ausgebildeten Einströmkörper K, der um ein Rohr R angeordnet ist, gebildet. Dabei dient die äußere Wandung A des Rohrs R als Wandung bzw. Begrenzung. Von der Oberfläche A des Rohrs R und der innen liegenden Seite des Einströmkörpers K wird dabei der Spalt B ausgebildet. Auch somit ist eine Trennung der hier dargestellten beiden Gasrohre G1 und G2 möglich. Angedeutet ist die Möglichkeit mehrerer Gaseinlässe C sowie einer zentral angeordneten Messkammer C sowie diese flankierende Gaseinlässe H1 und H2. Insofern ist die Ausführungsform gemäß Figur 15 sowohl rotationssymmetrisch (bezüglich des Mittelpunktes des Rohres bzw. des Einströmkörpers K) als auch spiegelsymmetrisch bezüglich der Messkammer C. Diese Ausführungsform stellt jedoch lediglich ein Beispiel für eine rotationssymmetrische Ausbildung der Gasschleusenanordnung dar, für den Einströmkörper K kommen auch alle anderen in den Figuren 2 bis 15 dargestellten Varianten der Ausbildung eines Einströmkörpers K in Frage.
In Figur 16 ist eine Ausführungsform dargestellt, in der das Rohr R ca. in der Mitte liegend des Einströmkörpers K unterbrochen ist. In der in Figur 16 dargestellten Ausführungsform liegt diese Unterbrechung auf Höhe der Messkammer C bzw. der Möglichkeit der Absaugung AS. Für diesen Fall liegt der Gasraum G2 im Inneren des Rohres R, wobei die Gasräume G1 und G2 voneinander getrennt angeordnet sein können. Dies kann beispielsweise durch einen Verschluss des Rohres bewerkstelligt werden.
In den beiden letzten Figuren sind aus Gründen der Übersichtlichkeit die in Spalt 3 angeordneten Mittel zur Manipulation der Strömungen nicht dargestellt.

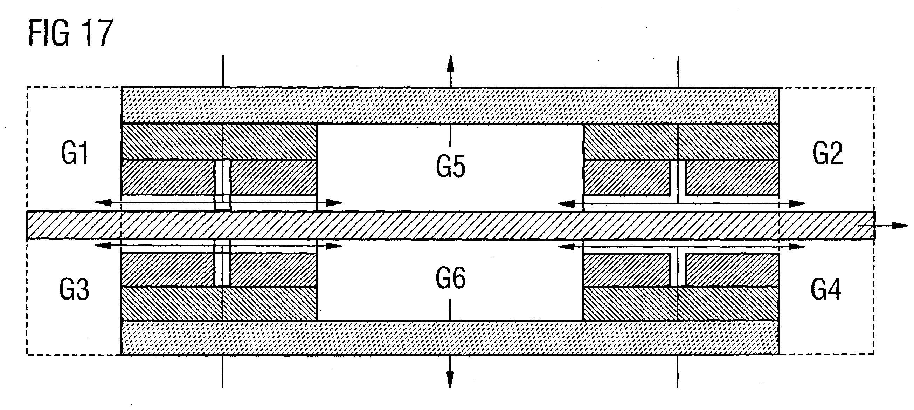

Figur 17 zeigt eine Beschichtungsvorrichtung in die mehrere erfindungsgemäße Gasschleusen integriert sind. Aus Gründen der Übersichtlichkeit sind die Ausführungsformen der Gasschleusen in diesem Fall nicht dargestellt.
In einer ersten Ausführungsform besitzt die Beschichtungsvorrichtung zwei Beschichtungskammern G5 und G6, welche jeweils eine Absaugung besitzen (durch den Pfeil angedeutet). Diese Beschichtungskammern G5 und G6 können auf dem gleichen Druckniveau arbeiten, müssen dies jedoch nicht. Dargestellt ist ein Längsschnitt durch die Beschichtungsvorrichtung von der Seite. G1, G2, G3 und G4 können in diesem Fall die Umgebung darstellen, weshalb für die Drücke gilt: P(G1) = P(G2) = P(G3) = P(G4). P(G5) kann größer oder kleiner als P(G1), P(G2), P(G3) oder P(G4) sein. Gleiches gilt für P(G6). Auf jeden Fall ist der Druck in allen vier Schleusen größer als P(G1), P(G2), P(G3), P(G4), P(G5) und P(G6). Damit ist der Gasraum G5 und der Gasraum G6 von der Umgebung getrennt.
Das Substrat kann nun kontinuierlich durch die Anlage bewegt werden (und zwar berührungsfrei), ohne die Gastrennung der Räume G5 und G6 zu verlieren (es muss aber nicht kontinuierlich bewegt werden). In dem gezeigten Fall würde das Substrat oben und unten beschichtet (es könnte aber auch einseitig beschichtet werden, hierfür müsste die Anlage nur den Teil oberhalb des Substrates (Beschichtung oben), bzw. unterhalb des Substrates (Beschichtung unten) aufweisen).
In einer zweiten Ausführungsform ist es jedoch ebenso denkbar, dass ein zylinderförmiges Substrat, beispielsweise ein Rohr, durch die dargestellte Beschichtungsvorrichtung geführt wird. In diesem Fall sind die Gasräume G1 und G3, G2 und G4 sowie G5 und G6 miteinander verbunden; es liegen in diesem Fall nur zwei Gasschleusen, die zylinderförmig um das Rohr ausgebildet sind, vor.
In jedem Fall sind die Gasschleusen jedoch wie voranstehend beschrieben ausgebildet.

## Patentansprüche

1. Gasschleuse (I) zur Trennung zweier Gasräume (G1, G2), umfassend
a) mindestens einen Einströmkörper (K), der mindestens einen Einlasskanal (H) für ein Gas aufweist, der in eine erste Seite des Einströmkörpers (K) mündet,
b) eine beabstandet zur ersten Seite des mindestens einen Einströmkörpers (K) angeordnete Wandung (A), wobei zwischen der Wandung (A) und dem mindestens einen Einströmkörper (K) ein Spalt (B), der in fluidischer Verbindung mit dem Einlasskanal (H) steht, ausgebildet ist,
c) mindestens zwei Ausströmöffnungen (i1, i2) für das Gas, die in fluidischer Verbindung mit dem Spalt (B) stehen,
wobei in der den mindestens einen Einströmkörper (K) begrenzenden ersten Seite und/oder in der der ersten Seite des Einströmkörpers (K) zugewandten Seite der Wandung (A) mindestens ein Mittel zur Manipulation der Strömung im Spalt (B) vorhanden ist,
**dadurch gekennzeichnet,**
**dass** der mindestens eine Einströmkörper (K) mindestens zwei Einlasskanäle (H1, H2, ..., Hn) für ein Gas aufweist und der Spalt (B) in fluidischer Verbindung mit den mindestens zwei Einlasskanälen (H1, H2, ..., Hn) steht, wobei mindestens eine Absaugvorrichtung (AS), über die zugeführtes Gas abgesaugt wird, zwischen den Einlasskanälen (H1, H2, ..., Hn) angeordnet ist.

2. Gasschleuse (I) nach einem der vorhergehenden Ansprüche, **dadurch gekennzeichnet, dass** die den mindestens einen Einströmkörper (K) begrenzende erste Seite und/oder die der ersten Seite des Einströmkörpers (K) zugewandte Seite der Wandung (A) mindestens eine, bevorzugt eine Mehrzahl von der ersten Seite des Einströmkörpers ausgehende und in diesen hineinragende bzw. von der der ersten Seite des Einströmkörpers (K) zugewandten Seite der Wandung (A) ausgehende und in die Wandung (A) hineinragende Aussparungen (E) aufweist.

3. Gasschleuse (I) nach einem der vorhergehenden Ansprüche, **dadurch gekennzeichnet, dass** die den mindestens einen Einströmkörper (K) begrenzende erste Seite und/oder die der ersten Seite des Einströmkörpers (K) zugewandte Seite der Wandung (A) mindestens eine, bevorzugt eine Mehrzahl von der ersten Seite des Einströmkörpers ausgehende und in den Spalt (B) hineinragende bzw. von der der ersten Seite des Einströmkörpers (K) zugewandten Seite der Wandung (A) ausgehende und in den Spalt (B) hineinragende Erhebungen (F) aufweist.

4. Gasschleuse (I) nach den beiden vorhergehenden Ansprüchen, **dadurch gekennzeichnet, dass** mindestens eine Aussparung (E) und mindestens eine Erhebung (F) vorhanden sind.

5. Gasschleuse (I) nach einem der vorhergehenden Ansprüche, **dadurch gekennzeichnet, dass** sie bezüglich des mindestens einen Einlasskanals (H) spiegelsymmetrisch und/oder bezüglich einer parallel zur Gasschleuse verlaufenden Achse rotationssymmetrisch aufgebaut ist.

6. Gasschleuse (I) nach einem der vorhergehenden Ansprüche, **dadurch gekennzeichnet, dass** die Ausströmöffnungen (i1, i2) so angeordnet sind, dass die Ausströmrichtung der ersten Ausströmöffnung (i1) der Ausströmrichtung der zweiten Ausströmöffnung entgegengesetzt ist.

7. Gasschleuse (I) nach einem der vorhergehenden Ansprüche, **dadurch gekennzeichnet, dass** der Spalt (B) im Wesentlichen lotrecht zum mindestens einen Einlasskanal (H) verläuft.

8. Gasschleuse (I) nach einem der vorhergehenden Ansprüche, **dadurch gekennzeichnet, dass** auf der dem Einströmkörper (K) abgewandten Seite der Wandung (A)
a) mindestens ein weiterer Einströmkörper (K') angeordnet ist, oder
b) eine Mehrzahl von abwechselnd angeordneten Einströmkörpern (K', K", ..., Kn) und Platten (A2, A3, ..., An-1) angeordnet ist.

9. Beschichtungsvorrichtung oder Wärmebehandlungsvorrichtung, umfassend mindestens eine Gasschleuse nach einem der vorhergehenden Ansprüche.

10. Verwendung einer Gasschleuse nach einem der Ansprüche 1 bis 7 zur Aufrechterhaltung eines bestehenden Konzentrationsgradienten eines und/oder mehrerer Gase und/oder zur Aufrechterhaltung einer Separierung verschiedener Gase in den zwei Gasräumen (G1, G2).

## Claims

1. A gas lock (I) for separating two gas spaces (G1, G2), comprising
a) at least one inflow body (K) which has at least one inlet channel (H) for a gas which opens into a first side of the inflow body (K),
b) a wall (A) arranged spaced apart from the first side of the at least one inflow body (K), wherein a gap (B) which is in fluidic communication with the inlet channel (H) is formed between the wall (A) and the at least one inflow body (K),
c) at least two outflow openings (i1, i2) for the gas which are in fluidic communication with the gap (B),
wherein at least one means for manipulating the flow in the gap (B) is present in the first side which delimits the at least one inflow body (K) and/or in the side of the wall (A) which faces the first side of the inflow body (K),
**characterised in that**
the at least one inflow body (K) has at least two inlet channels (H1, H2, ..., Hn) for a gas and the gap (B) is in fluidic communication with the at least two inlet channels (H1, H2, ..., Hn), with at least one extraction device (AS) via which supplied gas is extracted being arranged between the inlet channels (H1, H2, ..., Hn).

2. A gas lock (I) according to one of the preceding claims, **characterised in that** the first side which delimits the at least one inflow body (K) and/or that side of the wall (A) which faces the first side of the inflow body (K) has at least one, preferably a plurality of, cutout(s) (E) which start from the first side of the inflow body and extend thereinto or which start from that side of the wall (A) which faces the first side of the inflow body (K) and extend into the wall (A).

3. A gas lock (I) according to one of the preceding claims, **characterised in that** the first side which delimits the at least one inflow body (K) and/or that side of the wall (A) which faces the first side of the inflow body (K) has at least one, preferably a plurality of, elevation(s) (F) which start from the first side of the inflow body and extend into the gap (B) or which start from that side of the wall (A) which faces the first side of the inflow body (K) and extend into the gap (B).

4. A gas lock (I) according to the preceding two claims, **characterised in that** at least one cutout (E) and at least one elevation (F) are present.

5. A gas lock (I) according to one of the preceding claims, **characterised in that** it is constructed mirror-symmetrically with respect to the at least one inlet channel (H) and/or rotationally symmetrically with respect to an axis running parallel to the gas lock.

6. A gas lock (I) according to one of the preceding claims, **characterised in that** the outflow openings (i1, i2) are arranged such that the outflow direction of the first outflow opening (i1) is opposite to the outflow direction of the second outflow opening.

7. A gas lock (I) according to one of the preceding claims, **characterised in that** the gap (B) runs substantially perpendicularly to the at least one inlet channel (H).

8. A gas lock (I) according to one of the preceding claims, **characterised in that** on the side of the wall (A) remote from the inflow body (K)
a) there is arranged at least one further inflow body (K'), or
b) there is arranged a plurality of alternately arranged inflow bodies (K', K",..., Kn) and plates (A2, A3, ..., An-1).

9. A coating device or heat treatment device, comprising at least one gas lock according to one of the preceding claims.

10. Use of a gas lock according to one of Claims 1 to 7 for maintaining an existing concentration gradient of a and/or a plurality of gas(es) and/or for maintaining a separation of different gases in the two gas spaces (G1, G2).

## Revendications

1. Ecluse à gaz (I) destinée à séparer deux compartiments à gaz (G1, G2), comprenant
a) au moins un corps d'admission de flux (K) qui présente au moins un canal d'entrée (H) pour un gaz qui débouche dans un premier côté du corps d'admission de flux (K),
b) une paroi (A) disposée à distance du premier côté du corps d'admission de flux (K) au moins au nombre de un, un interstice (B) qui est en liaison fluidique avec le canal d'entrée (H) étant constitué entre la paroi (A) et le corps d'admission de flux (K) au moins au nombre de un,
c) au moins deux ouvertures d'évacuation de flux (i1, i2) pour le gaz qui sont en liaison fluidique avec l'interstice (B),
au moins un moyen de manipulation de l'écoulement étant présent dans l'interstice (B) dans le premier côté limitant le corps d'admission de flux (K) au moins au nombre de un et/ou dans le côté de la paroi (A) tourné vers le premier côté du corps d'admission de flux (K),
**caractérisée en ce que**
le corps d'admission de flux (K) au moins au nombre de un présente au moins deux canaux d'entrée (H1, H2, ..., Hn) pour un gaz, et l'interstice (B) est en liaison fluidique avec les canaux d'entrée (H1, H2, ..., Hn) au moins au nombre de deux, au moins un dispositif d'aspiration (AS) par le biais duquel du gaz acheminé est aspiré étant disposé entre les canaux d'entrée (H1, H2, ..., Hn).

2. Ecluse à gaz (I) selon l'une des revendications précédentes, **caractérisée en ce que** le premier côté limitant le corps d'admission de flux (K) au moins au nombre de un et/ou le côté de la paroi (A) tourné vers le premier côté du corps d'admission de flux (K) présente au moins un, de préférence une pluralité d'évidements (E) partant du premier côté du corps d'admission de flux et pénétrant dans celui-ci ou respectivement partant du côté de la paroi (A) tourné vers le premier côté du corps d'admission de flux (K) et pénétrant dans la paroi (A).

3. Ecluse à gaz (I) selon l'une des revendications précédentes, **caractérisée en ce que** le premier côté limitant le corps d'admission de flux (K) au moins au nombre de un et/ou le côté de la paroi (A) tourné vers le premier côté du corps d'admission de flux (K) présente au moins une, de préférence une pluralité de surélévations (F) partant du premier côté du corps d'admission de flux et pénétrant dans l'interstice (B) ou respectivement partant du côté de la paroi (A) tourné vers le premier côté du corps d'admission de flux (K) et pénétrant dans l'interstice (B).

4. Ecluse à gaz (I) selon les deux revendications précédentes, **caractérisée par** la présence d'au moins un évidement (E) et d'au moins une surélévation (F).

5. Ecluse à gaz (I) selon l'une des revendications précédentes, **caractérisée en ce qu'**elle est construite en symétrie miroir par rapport au canal d'entrée (H) au moins au nombre de un et/ou de façon symétrique en rotation par rapport à un axe parallèle à l'écluse à gaz.

6. Ecluse à gaz (I) selon l'une des revendications précédentes, **caractérisée en ce que** les ouvertures d'évacuation de flux (i1, i2) sont disposées de telle sorte que le sens d'évacuation de flux de la première ouverture d'évacuation de flux (i1) est opposé au sens d'évacuation de flux de la deuxième ouverture d'évacuation de flux.

7. Ecluse à gaz (I) selon l'une des revendications précédentes, **caractérisée en ce que** l'interstice (B) est essentiellement perpendiculaire au canal d'entrée (H) au moins au nombre de un.

8. Ecluse à gaz (I) selon l'une des revendications précédentes, **caractérisée en ce que**, sur le côté de la paroi (A) éloigné du corps d'admission de flux (K)
a) il est disposé au moins un autre corps d'admission de flux (K'), ou
b) il est disposé une pluralité de corps d'admission de flux (K', K", ..., Kn) et de plaques (A2, A3, ..., An-1) disposés de façon alternée.

9. Dispositif de revêtement ou dispositif de traitement thermique, comprenant au moins une écluse à gaz selon l'une des revendications précédentes.

10. Utilisation d'une écluse à gaz selon l'une des revendications 1 à 7 pour le maintien d'un gradient de concentration existant d'un et/ou de plusieurs gaz et/ou pour le maintien d'une séparation de différents gaz dans les deux compartiments à gaz (G1, G2).
